# EUROPÄISCHE PATENTANMELDUNG

(11) **EP 2 549 280 A1**
(43) Veröffentlichungstag der Anmeldung: **23.01.2013**
(21) Anmeldenummer: 12005262.6
(22) Anmeldetag: 18.07.2012
(51) Int. Cl.: G01R 21/133, G01D 4/00

(54) **System und Verfahren zur Bestimmung elektrischer Kenngrössen**

(30) Priorität: 19.07.2011 DE 102011107932
(71) Anmelder: EurA Consult GmbH, 73479 Ellwangen (DE)
(72) Erfinder: Seitz, Gabriele, 73479 Ellwangen (DE)
(74) Vertreter: Weihrauch, Frank

(57) **Zusammenfassung**

Die Erfindung betrifft ein Verfahren zur Bestimmung elektrischer Kenngrößen in einem verzweigten Stromnetz (2), sowie ein System zur Durchführung des Verfahrens.

Das System umfasst erfindungsgemäß eine zentrale Steuer- und Auswerteeinheit (3), welche dazu in der Lage ist, einen Kenngrößenermittlungsvorgang zu starten, eine zentrale Spannungsmesseinheit (4), sowie eine Mehrzahl von Strommesseinheiten (5.1.1-5.2.3), wobei durch die zentrale Spannungsmesseinheit und durch die Strommesseinheiten Augenblickswerte einer Spannung beziehungsweise eines Stroms messbar sind und übertragbar (6) zur Verfügung gestellt werden und wobei durch die zentrale Steuer- und Auswerteeinheit ein Signal zur zeitgleichen Messung der Augenblickswerte von Spannung und Strom an die zentrale Spannungsmesseinheit und an die Strommesseinheiten über die Verbindungen ausgegeben wird, wobei diesem Signal ein, von der zentralen Steuer- und Auswerteeinheit ausgegebener, Zeitstempel beigegeben ist und die Übertragung der Augenblickswerte durch Verbindungen von der zentralen Spannungsmesseinheit und den Strommesseinheiten zu der zentralen Steuer- und Auswerteeinheit erfolgt und die zentrale Steuer- und Auswerteeinheit aus den Augenblickswerten von Spannung und Strom die elektrischen Kenngrößen, insbesondere die Wirkleistung und die Wirkarbeit, berechnet.

## Beschreibung

Die Erfindung betrifft ein System und das dazugehörige Verfahren zur Bestimmung elektrischer Kenngrößen, insbesondere der Wirkleistung und der aufgenommenen Wirkenergie, beziehungsweise der verrichteten Wirkarbeit, dezentraler Verbraucher an beliebigen Positionen innerhalb eines Stromnetzes.

Systeme, Vorrichtungen und Verfahren zur Bestimmung der Wirkleistung sind generell aus dem Stand der Technik bekannt.
Dabei kommen in der Regel sogenannte Strom- oder Energiezähler zum Einsatz, welche, vorrangig auf elektronischem Wege über Sensoren und Schaltungen, den Strom und die Spannung, sowie die zwischen diesen auftretende Phasenverschiebung, in dem jeweiligen Stromnetz ermitteln.
Aus den ermittelten Daten für Strom, Spannung und Phasenverschiebung ist es dann möglich, die in dem jeweiligen Stromnetz anliegende Wirkleistung zu ermitteln.

In Zeiten steigender Energiekosten wird es speziell für produzierende Unternehmen zunehmend wichtiger, innerhalb eines Stromnetzes die Wirkleistung einzelner Verbraucher zu bestimmen um diese gezielt ansteuern und deren Effektivität verbessern zu können.

Würde man ein solches Vorhaben mit den, aus dem Stand der Technik bekannten, Energiezählern umsetzen wollen, so würde es notwendig werden, für jeden einzelnen Verbraucher einen derartigen Energiezähler separat bereitzustellen und die messtechnischen Signale oder Werte aufwändig aufzubereiten. Dies wäre mit einem immensen Installations- und Messaufwand verbunden und somit für Stromnetze mit vielen Verbrauchern unwirtschaftlich und teuer.
Hinzu kommt, dass die bekannten Energiezähler einen entsprechend großen Bauraum benötigen und somit eine nachträgliche Installation dieser in bestehende Stromnetze oftmals nicht durchführbar ist.

Um diese Nachteile zu beseitigen sind aus dem Stand der Technik ebenfalls Vorrichtungen und Verfahren bekannt, welche an jedem Verbraucher nur den jeweils anliegenden Wert des Stroms ermitteln, diesen dann mit einem hinterlegten Spannungswert verrechnen und unter Berücksichtigung eines zuvor ermittelten und für den jeweiligen Verbraucher hinterlegten Wirkfaktors, die Wirkleistung bestimmt.

Eine derartige Vorrichtung ist beispielsweise in Druckschrift DE 198 27 345 B4 offenbart und weist mehrere Messstellen, sowie eine zentrale Recheneinheit auf.

Die Messstellen sind dabei jeweils einem Verbraucher zugeordnet und erfassen die jeweils an dem Verbraucher anliegenden Stromwerte.
Anschließend werden die erfassten Stromwerte an die Recheneinheit übertragen und dort mit einem Spannungssignal zusammengeführt.
Das Spannungssignal wird hierzu an ausgewählten Punkten des Stromnetzes ermittelt.

Die offenbarte Erfindung sieht nachteilig vor, dass zur Konditionierung der Vorrichtung und somit zur Bestimmung der Wirkleistung, an jedem einzelnen Verbraucher für charakteristische Betriebszustände gültige Kennwerte für die Höhe des Wirkleistungsbezugs und des Leistungsfaktors bestimmt werden müssen. Die ermittelten Kennwerte werden anschließend zur weiteren Verwendung in einer Datenbank hinterlegt und abhängig von der Schwankung der Netzspannung zur Berechnung der Wirkleistung der einzelnen Verbraucher herangezogen.

Diese Vorabermittlung der charakteristischen Kennwerte jedes Verbrauchers in unterschiedlichen Betriebszuständen führt zu einem großen Vorbereitungsaufwand und somit zu hohen Vorbereitungs- und Versuchsaufwendungen.

Im Hinblick auf die Nachteile des Standes der Technik ist es somit die Aufgabe der vorliegenden Erfindung, ein System und ein zugehöriges Verfahren aufzuzeigen, welche eine einfache und kostengünstige Bestimmung der elektrischen Kenngrößen, insbesondere der Wirkleistung und der Wirkarbeit einer Vielzahl elektrischer Verbraucher innerhalb eines Wechselspannungsnetzes mit einem zentralen Einspeisepunkt ermöglichen.

Die Aufgabe wird in Bezug auf das System durch die im Patentanspruch 1 aufgeführten Merkmale gelöst. Bevorzugte Weiterbildungen des Systems ergeben sich aus den Ansprüchen 2 bis 6.

In Bezug auf das Verfahren wird die Aufgabe durch die im Patentanspruch 7 aufgeführten Merkmale gelöst. Bevorzugte Weiterbildungen des Verfahrens ergeben sich aus den Ansprüchen 8 und 9.

Ein erfindungsgemäßes System zur Bestimmung elektrischer Kenngrößen von Verbrauchern in einem verzweigten Stromnetz weist eine zentrale Steuer- und Auswerteeinheit, nachfolgend auch als Controller bezeichnet, eine zentrale Spannungsmesseinheit, sowie eine Mehrzahl von Strommesseinheiten auf.

Erfindungsgemäß sind dabei zum einen die Strommesseinheiten den jeweiligen Verbrauchern zugeordnet.
Zum anderen ist die zentrale Steuer- und Auswerteeinheit über Verbindungen sowohl mit der zentralen Spannungsmesseinheit, als auch mit den Strommesseinheiten, verbunden.

Durch die zentrale Spannungsmesseinheit erfolgt besonders vorteilhaft eine Messung der in dem Stromnetz anliegenden Spannung U an einer zentralen Spannungsmessstelle innerhalb des Stromnetzes.
Im Gegensatz zu herkömmlichen Systemen wird bei einem erfindungsgemäßen System nur eine einzige Spannungsmessstelle innerhalb des Stromnetzes benötigt, wodurch zum einen der gerätetechnische und Installationsaufwand und zum anderen der notwendige Messaufwand verringert wird.
Durch die einspeisungspunktnahe Messung der Spannung wird als besonderer Vorteil zudem erreicht, dass die im Stromnetz bis zum Verbraucher auftretenden Verlustleistungsanteile und Verzerrungen, insbesondere durch Spannungsabfall unter Last, in der Bestimmung der letztlich resultierenden Wirkleistung und Wirkarbeit mit erfasst werden.

Die Messung der Spannung U durch die zentrale Spannungsmesseinheit erfolgt auf an sich bekannte Art und Weise entweder digital oder analog, wobei eine Messung von Augenblickswerten der Wechselspannung statt lediglich der Effektivspannung erfolgt.

Parallel zur Messung der anliegenden Spannung U an der zentralen Spannungsmesseinheit, wird über die Strommesseinheiten der Wert des, die jeweiligen Leiter zum Anschluss des Verbrauchers durchfließenden, Stromes I gemessen. Wie bei der Spannungsmessung erfolgt auch hier eine Messung der Augenblickswerte.

Handelt es sich um Verbraucher eines Mehrphasenstromkreises, wie dies zum Beispiel bei einem Dreiphasen-Wechselstromkreis der Fall ist, so wird jedem Leiter eine separate Strommesseinheit zugeordnet. In einem solchen Fall sind die Strommesseinheiten jeweils einzeln mit dem Controller verbunden, oder aber, beispielsweise über einen seriellen BUS, so zusammengefasst, dass eine BUS-Leitung von Strommesseinheit zu Strommesseinheit durchgeschleift wird.

Die Messung des Stromes I an dem jeweiligen Verbraucher durch die Strommesseinheiten erfolgt vorzugsweise auf an sich bekannte Weise unter Nutzung des Hall-Effekts, darüber hinaus kann jedoch erfindungsgemäß auch jede andere geeignete Form der Strommessung, beispielsweise induktiv, angewendet werden. Es ist zweckmäßig, die Strommessung berührungslos auszuführen um eine galvanische Trennung von Stromleitung und Stromsensor zu gewährleisten.

Durch die zentrale Spannungsmesseinheit und durch die Strommesseinheiten werden Augenblickswerte der, in dem Stromnetz anliegenden Spannung U, beziehungsweise des, die dem jeweiligen Verbraucher zugeordneten Leiter durchfließenden Stromes I gemessen und es werden die gemessenen Augenblickswerte übertragbar zur Verfügung gestellt.

Hierzu ist durch die zentrale Steuer- und Auswerteeinheit besonders vorteilhaft ein Kenngrößenermittlungsvorgang, zur Ermittlung der Augenblickswerte der Spannung U und des jeweiligen Stromes I, startbar.

Erfindungsgemäß erfolgt die Ermittlung der jeweiligen Augenblickswerte von Spannung und Strom exakt zeitgleich, wodurch sich eine exakte zeitliche Zugehörigkeit der jeweiligen Augenblickswerte von Spannung und Strom zueinander ergibt.

Für die Gewährleistung der zeitgleichen Ermittlung der Spannungs- und Stromwerte wird diesen, durch den Controller, eine Codierung beigegeben, nachfolgend Zeitstempel genannt, über welchen eine eindeutige Zuordnung der zeitlich zueinander gehörigen jeweiligen Spannungs- und Stromwerte ermöglicht wird.
Zusätzlich werden die gemessenen Stromwerte so codiert, dass eine eindeutige Zuordnung dieser zu dem jeweiligen Leiter und Verbraucher gesichert ist.

Die Übertragung der gemessenen Augenblickswerte der Spannung U und des, an dem jeweiligen Verbraucher anliegenden Stromes I, erfolgt erfindungsgemäß über die Verbindungen der zentralen Spannungsmesseinheit und der Strommesseinheiten zu der zentralen Steuer- und Auswerteeinheit.

Als besonderer Vorteil der Erfindung ist es durch die Zuordnungen der gemessenen Augenblickswerte mittels Zeitstempel und verbraucherbezogenen Codierungen hierbei nicht notwendig, dass die Übertragung der Spannungs- und Stromwerte an die zentrale Steuer- und Auswerteeinheit zeitgleich erfolgen.
Vielmehr kann in diesem Fall auch eine zeitversetzte Übertragung der Werte erfolgen, was insbesondere für die Verwendbarkeit eines BUS-Systems vorteilhaft ist. Aufgrund des notwendigen Einreihens der Werte in die Datenübertragung treten zwangsläufige Zeitversätze auf. Zudem können BUS-Systeme ohne gesteigerte Anforderungen an die Übertragungsraten verwandt werden.

Im Anschluss an die Übertragung der Augenblickswerte der Spannung U und des, durch den jeweiligen Verbraucher fließenden Stromes I, werden in dem Controller die zu ermittelnden elektrischen Kenngrößen berechnet.

Bei den zu ermittelnden elektrischen Kenngrößen handelt es sich erfindungsgemäß insbesondere um die Größen der Wirkleistung P und, über die Zeit, der verrichteten Wirkarbeit beziehungsweise aufgenommenen Wirkenergie.
Üblicherweise wird nach dem Stand der Technik die Wirkleistung P bei induktiven oder kapazitiven Lasten und zumindest im wesentlichen sinusförmigen Verläufen von Spannung U und Strom I über die Formel *P*=*U·I·*cos*ϕ* berechnet.
Bei den dazu verwendeten Spannungs- und Stromwerten U und I handelt es sich um Effektivwerte.
Dabei stellt cos*ϕ* den sogenannten Wirkfaktor dar. Dieser berücksichtigt die Phasenverschiebung ϕ bei nichtohmschen Lastenanteilen. Die Phasenverschiebung ϕ muss insbesondere dann mehr oder weniger aufwändig bestimmt werden, wenn gleichzeitig induktive, kapazitive oder ohmsche Verbrauchercharakteristika in dem zu betrachtenden Stromnetz auftreten.

Als besonderen Vorteil lässt die erfindungsgemäße Lösung zwei mögliche Wege zur Ermittlung der Wirkleistung zu.

Die zeitgleich durchgeführten Messungen von Augenblickswerten von Spannung und Strom ermöglichen eine Bestimmung der Augenblickswirkleistung. Bei ausreichender Anzahl von Augenblickswerten der Wirkleistung über einen definierten Zeitraum kann über einen geeigneten Algorithmus anschließend die effektive Wirkleistung des jeweiligen Verbrauchers errechnet werden. Es bedarf als besonderen Vorteil nicht mehr des Umweges über die Bestimmung der Phasenverschiebung. Insbesondere bei Verzerrungen und Abweichungen von sinusförmigen Verläufen ist eine genauere Bestimmung der Wirkleistung möglich.

Zum anderen ist es durch die Steuer- und Auswerteeinheit alternativ möglich, über die gemessenen Augenblickswerte von Spannung und Strom in einem definierten Zeitbereich, zunächst die Effektivwerte sowie die zeitlichen Verläufe von Spannung und Strom zu ermitteln. Aus diesen zeitlichen Verläufen können dann weiterführend die Phasenverschiebung ϕ und der Wirkfaktor cos*ϕ* bestimmt werden, welche anschließend zusammen mit den Effektivwerten von Spannung U und Strom I zur Ermittlung der Wirkleistung P der Verbraucher dienen.

Darüber hinaus können als weiterer Vorteil aus der jederzeitigen verbraucherbezogenen Ermittelbarkeit der Phasenverschiebung ϕ weiterführend beispielsweise Rückschlüsse auf das Betriebsverhalten des jeweiligen Verbrauchers, auch gesondert nach den jeweiligen Betriebszuständen, beispielsweise in eine Anlaufphase, gezogen werden.

Ferner kann aus den gemessenen Augenblickswerten von Spannung und Strom auch die Scheinleistung S des jeweiligen Verbrauchers ermittelt werden.

Durch die zentrale Steuer- und Auswerteeinheit sind die ermittelten beziehungsweise berechneten elektrischen Kenngrößen ausgebbar.
Die Ausgabe der elektrischen Kenngrößen erfolgt dabei beispielsweise visualisierbar oder archivierbar. Sie kann ferner für Steuerungszwecke, beispielsweise zur Durchführung von Vorrangschaltungen zur Vermeidung der Überschreitung von Lastgangprofilen oder für Notabschaltungen bei detektierten Störungen eines Verbrauchers, verwendet werden.

Ein erfindungsgemäßes System erlaubt somit nicht nur die Bestimmung und Ausgabe elektrischer Kenngrößen, vielmehr ermöglicht das System darüber hinaus durch die Ermittlung der Wirkleistung und Wirkenergie auch eine Beurteilung und Bewertung der Verbraucher in einem Stromnetz hinsichtlich deren Effizienz, Wirtschaftlichkeit und technischen Betriebsverhaltens.

Dabei zielt die Erfindung zwar in erster Linie auf die Verwendung an Stromnetzen mit Verbrauchern wie elektrischen Motoren oder Produktionsmaschinen ab, diese kann jedoch auch bei allen anderen denkbaren elektrischen Verbrauchern in einem Stromnetz eingesetzt werden.

Gerade in Stromnetzen mit einer Vielzahl elektrischer Verbraucher, wie es beispielsweise bei Produktionsanlagen von Betrieben der Fall ist, wird durch das erfindungsgemäße System eine unkomplizierte und vor allem kostengünstige Lösung zur Erfassung der elektrischen Kenngrößen der angeschlossenen Verbraucher und zur Bewertung deren Effizienz, beziehungsweise zur korrekten energetischen Bewertung des Gesamtsystems aller Verbraucher in dem jeweiligen Stromnetz bereitgestellt.

Darüber hinaus wird es den Betrieben durch die aufgezeigte technische Lösung ermöglicht, die bei der Herstellung ihrer Produkte anfallenden Energiekosten konkret auf die einzelnen Verbraucher und die durch diese bewirkten Prozessschritte umzulegen. Dadurch können die jeweiligen Prozessschritte optimiert und somit die Herstellungskosten für das jeweils produzierte Produkt insgesamt gesenkt werden.

In einer bevorzugten Weiterbildung der Erfindung sind der zentralen Spannungsmesseinheit und/oder den Strommesseinheiten Speicherelemente zugeordnet, durch welche die gemessenen Augenblickswerte der Spannung und des jeweiligen Stromes zwischenspeicherbar sind.
Eine derartige Zwischenspeicherung der gemessenen Werte ist insbesondere dann von Vorteil, wenn die Übertragung der Werte an die zentrale Steuer- und Auswerteeinheit nicht in Echt-Zeit, sondern zeitversetzt zu dem eigentlichen Messvorgang der Werte durchführbar sein soll.
Durch eine zeitversetzte Übertragung der gemessenen Spannungs- und Stromwerte kann beispielsweise eine Überlastung der Verbindung zwischen der zentralen Steuer- und Auswerteeinheit und der zentralen Spannungsmesseinheit, beziehungsweise zwischen der zentralen Steuer- und Auswerteeinheit und den Strommesseinheiten, aufgrund der übertragenen Werte, wirkungsvoll verhindert werden.
In einem solchen Fall erfolgt die Übertragung der Spannungs- und Stromwerte an den Controller erst dann, wenn dieser die gemessenen Werte aus dem jeweiligen Zwischenspeicher abfragt.

Die Übertragung der Spannungs- beziehungsweise Stromwerte an die zentrale Steuer- und Auswerteeinheit erfolgt in einer vorteilhaften Ausbildung der Erfindung durch Modulation der jeweiligen Werte auf das Stromnetz.
Das Verfahren der Aufmodulation auf das Stromnetz wird in diesem Zusammenhang als aus dem Stand der Technik bekannt angesehen, weshalb auf dieses hier nicht näher eingegangen werden soll.
Die Aufmodulation der Spannungs- und Stromwerte auf das vorhandene Stromnetz hat den besonderen Vorteil, dass keine zusätzlichen Verbindungen zwischen dem Controller und der zentralen Spannungsmesseinheit, beziehungsweise zwischen dem Controller und den Strommesseinheiten vorgesehen werden müssen.
Der notwendige Installationsaufwand für ein erfindungsgemäßes System kann somit effizient verringert werden.

In einer ebenso bevorzugten Weiterbildung der Erfindung ist die Verbindung der Steuer- und Auswerteeinheit mit der zentralen Spannungsmesseinheit und den Strommesseinheiten drahtlos ausgebildet.
In diesem Fall weisen zentrale Spannungsmesseinheit und Strommesseinheiten jeweils separate Sender zum Senden der gemessenen Werte und die Steuer- und Auswerteeinheit einen entsprechenden Empfänger zum Empfang der gesendeten Werte auf. Eine derart drahtlose Verbindung kann beispielsweise per Funk oder per W-LAN Netzwerk realisiert sein. Darüber hinaus sind auch alle anderen Arten drahtloser Verbindungen denkbar.

In jedem Fall entfallen durch die Verwendung einer Drahtlos-Verbindung besonders vorteilhaft zusätzliche Verbindungsleitungen zwischen der Steuer- und Auswerteeinheit und der Spannungsmess-, beziehungsweise den Strommesseinheiten.

Eine weitere bevorzugte Variante des erfindungsgemäßen Systems sieht vor, dass die zentrale Spannungsmesseinheit in die zentrale Steuer- und Auswerteeinheit integriert ist. Hierdurch kann einerseits der Installationsaufwand für ein erfindungsgemäßes System nochmals vorteilhaft verringert werden, andererseits wird durch die Integration der zentralen Spannungsmesseinheit in die Steuer- und Auswerteeinheit der benötigte Bauraum zur Installation des Systems verkleinert.
Dies ist insbesondere dann von Vorteil, wenn ein erfindungsgemäßes System nachträglich in einem bestehenden Stromnetz mit wenigen baulichen Freiräumen installiert werden soll.

Bei einer Integration der zentralen Spannungsmesseinheit in die Steuer- und Auswerteeinheit sieht eine ebenso vorteilhafte Weiterbildung der Erfindung vor, dass die Verbindung zwischen Steuer- und Auswerteeinheit und zentraler Spannungsmesseinheit über einen internen Prozessorbus innerhalb des Controllers erfolgt. Da ein Prozessorbus in der Regel zu Datenübertragungs- und/oder Steuerungszwecken ohnehin in der Steuer- und Auswerteinheit vorhanden ist, wird dieser in der hier beschriebenen Weiterbildung besonders vorteilhaft gleichzeitig zur Übertragung der Daten zwischen zentraler Spannungsmesseinheit und Controller verwendet. Die Notwendigkeit, die Spannungswerte extern, beispielsweise über den externen BUS zu übertragen, entfällt.

Ein, mit einem erfindungsgemäßen System durchzuführendes Verfahren zur Bestimmung elektrischer Kenngrößen, insbesondere zur Bestimmung der Wirkleistung und der Wirkenergie elektrischer Verbraucher in einem Stromnetz, weist die nachfolgend beschriebenen Verfahrensschritte auf.

Zuerst wird in einem ersten Verfahrensschritt a) ein Kenngrößenermittlungsvorgang durch die zentrale Steuer- und Auswerteeinheit gestartet.
Dabei erfolgt der Start des Kenngrößenermittlungsvorgangs entweder manuell oder automatisch gesteuert.
Der Verfahrensschritt a) erfasst sämtliche vorbereitenden Maßnahmen zur Ermittlung der Kenngrößen innerhalb der Steuer- und Auswerteeinheit, insbesondere die Erzeugung des im Verfahrensschritt b) auszugebenden Signals und des Zeitstempels.

Nach dem Starten des Kenngrößenermittlungsvorgangs wird in Verfahrensschritt b) durch die Steuer- und Auswerteeinheit über die Verbindungen ein Signal zur zeitgleichen Messung einer Spannung und eines Stromes an die zentrale Spannungsmesseinheit und an die Strommesseinheiten ausgegeben. Dabei wird dem Signal erfindungsgemäß ein Zeitstempel beigegeben, mit dem im weiteren Verlauf eine zeitliche Zuordnung der ermittelten Spannungs- und Stromwerte ermöglicht wird.

In einem dritten Verfahrensschritt c) wird das, von dem Controller ausgegebene Signal mit Zeitstempel durch die zentrale Spannungsmesseinheit und durch die Strommesseinheiten empfangen.
Das Signal wird dabei insbesondere derart übertragen, dass nur eine geringstmögliche Zeitspanne zwischen dem Aussenden des Signals von dem Controller und dem Empfang des Signals in der zentralen Spannungsmesseinheit und in den Strommesseinheiten vorliegt. Optional ist es auch möglich, die Übertragungszeiten zu bestimmen und eine Rückrechnung vorzunehmen, um eine exakte Zeitgleichheit bei allen Messeinheiten herzustellen.
Der Empfang des Signals durch die zentrale Spannungsmesseinheit und durch die Strommesseinheiten, gegebenenfalls unter Rückrechnung der Übertragungszeit, stellt gleichermaßen den Start der Messungen von Spannung und Strom dar.

Nachdem das Signal von der zentralen Spannungsmesseinheit und den Strommesseinheiten empfangen wurde erfolgt in einem weiteren Verfahrensschritt d) die Durchführung der Messung der Augenblickswerte der in dem Stromnetz anliegenden Spannung und des, an dem jeweiligen Verbraucher anliegenden Stromes durch die zentrale Spannungsmesseinheit und durch die Strommesseinheiten.
Dabei werden, innerhalb eines Erfassungszyklus mit vorgegebener Gesamtzeitdauer, erfindungsgemäß zu einem ersten Zeitpunkt t₀ ein erster Augenblickswert und darauf aufbauend zu definierten Zeitpunkten tₙ weitere Augenblickswerte der Spannung und des Stromes gemessen.
Innerhalb des Verfahrensschrittes d) erfolgt in der zentralen Spannungsmesseinheit und in den Strommesseinheiten besonders vorteilhaft eine Zuordnung eines gemessenen Augenblickswertes zu dem jeweiligen Zeitpunkt t₀ bis tₙ als Wertepaar und ein Versehen der gebildeten Wertepaare mit dem, von der Steuer- und Auswerteeinheit ausgegebenen, Zeitstempel.

Anschließend werden die mit dem Zeitstempel versehenen Wertepaare in Verfahrensschritt e) über die Verbindungen von der zentralen Spannungsmesseinheit und den Strommesseinheiten an die zentrale Steuer- und Auswerteeinheit übertragen. Die Übertragung erfolgt dabei wahlweise per Modulation auf das Stromnetz oder über eine Drahtlosverbindung.

Bei Vorhandensein mehrerer Verbraucher in einem Stromnetz werden die Wertepaare der, dem jeweiligen Verbraucher zugeordneten, Strommesseinheiten, zusätzlich mit einer Codierung versehen, welche eine Zuordnung der Wertepaare zu dem jeweiligen Leiter beziehungsweise Verbraucher und dessen Identifikation innerhalb des Kenngrößenermittlungsvorgangs ermöglicht.

Die übertragenen und mit den Zeitstempeln versehenen Wertepaare der Spannung und des Stromes zu den jeweiligen Zeitpunkten t₀ bis tₙ werden in einem weiteren Verfahrensschritt f) in der Steuer- und Auswerteeinheit einander so zugeordnet, dass die Augenblickswerte der Spannung und des Stromes jeweils aus dem, mit dem gleichen Zeitstempel versehenen Wertepaar entnommen werden.

Hierbei spielt es besonders vorteilhaft keine Rolle, zu welchem Zeitpunkt die gemessenen Augenblickswerte an die Steuer- und Auswerteeinheit übertragen werden, da die Zeitstempel zu jedem beliebigen Zeitpunkt eine Zuordnung der Spannungs- und Stromwerte zueinander ermöglichen. Dieses Merkmal ermöglicht, insbesondere bei Verwendung eines BUS-Systems zur Übertragung der Wertepaare, deren geordnete Einreihung auf dem BUS und macht das Verfahren unanfällig gegenüber einem möglichen Datenstau in dem BUSSystem.

Aus den einander zugeordneten Augenblickswerten der Spannung und des Stromes werden in einem letzten Verfahrensschritt g) die gewünschten elektrischen Kenngrößen, insbesondere die Wirkleistung und die Wirkenergie, in der Steuerungs- und Auswerteeinheit berechnet.
Wie oben aufgeführt, wird die Berechnung der Wirkleistung erfindungsgemäß entweder über die, innerhalb des Erfassungszyklus gemessenen Augenblickswerte direkt, oder alternativ dazu über die Bestimmung der Phasenverschiebung zwischen den Spannungs- und Stromwerten und deren Multiplikation mit den Effektivwerten der Spannung und des Stromes durchgeführt.

Im Falle der Bestimmung der Phasenverschiebung umfasst ein erfindungsgemäßer Kenngrößenermittlungsvorgang so viele definierte Zeitpunkte t₀ bis tₙ, dass entsprechend den Anforderungen der Messaufgabe hinreichend genau die Verläufe der Spannungs- und Stromkurven, sowie deren Nulldurchgänge ermittelt werden können.

Die einander zugeordneten Wertepaare fungieren dabei als Stützstellen für die Spannungs- und Stromkurven.
Eine weitere besonders bevorzugte Weiterbildung der Erfindung sieht vor, dass die in Verfahrensschritt d) zugeordneten Wertepaare, innerhalb der zentralen Spannungsmesseinheit und innerhalb der Strommesseinheit, vor deren Übertragung an die Steuer- und Auswerteinheit zu Wertepaarblöcken zusammengefasst werden.

In der Steuer- und Auswerteeinheit erfolgt in einer weiteren Variante des erfindungsgemäßen Verfahrens, vor der Berechnung der elektrischen Kenngrößen, eine Ordnung der übertragenen Wertepaare, beziehungsweise Wertepaarblöcke bezüglich deren jeweils zugeordneten Zeitstempeln.
Dies ist insbesondere dann besonders von Vorteil, wenn durch den Controller anhand der in den übertragenen Wertepaaren vorliegenden Augenblickswerte Spannungs- und Stromverläufe über die Zeit bereitgestellt werden sollen.

Eine bevorzugte Weiterbildung des erfindungsgemäßen Verfahrens sieht vor, dass nach Ausführung des Verfahrensschrittes d) mindestens ein Wertepaar, beziehungsweise mindestens ein Wertepaarblock, temporär in dem Speicherelement der zentralen Spannungsmesseinheit und/oder der Strommesseinheiten gespeichert wird.

Eine derartige temporäre Speicherung der gemessenen Augenblickswerte von Spannung und Strom bewirkt besonders vorteilhaft, dass die Augenblickswerte nach deren Messen nicht zwingend unmittelbar an die Steuer- und Auswerteeinheit übertragen werden müssen, sondern beispielsweise erst auf Anfrage durch den Controller an diesen übertragen werden. Dadurch kann zum einen einer Überlastung der Verbindungen zwischen Steuer- und Auswerteeinheit und der zentralen Spannungsmesseinheit, beziehungsweise den Strommesseinheiten entgegengewirkt werden.
Zum anderen erlaubt die Zwischenspeicherung auch eine nachträgliche oder rückwirkende Berechnung der elektrischen Kenngrößen durch die Steuer- und Auswerteeinheit, beispielsweise bei Betriebstörungen der Leitungen oder der Steuer- und Auswerteeinheit.

Alternativ dazu können die ermittelten Wertepaare auch in einem Speicherelement in der Steuer- und Auswerteeinheit temporär gespeichert werden.

Die Erfindung wird als Ausführungsbeispiel anhand von
- Fig. 1: Prinzipdarstellung mit separater zentraler Spannungsmesseinheit
- Fig. 2: Prinzipdarstellung mit integrierter zentraler Spannungsmesseinheit
näher erläutert.

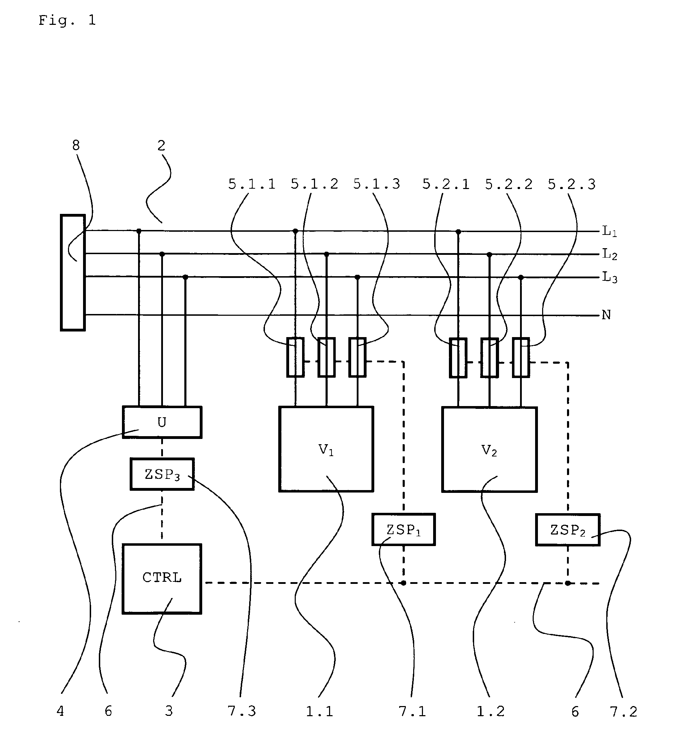

Fig. 1 zeigt in einer prinzipiellen Darstellung zwei Verbraucher 1 in einem bestehenden Stromnetz 2, wobei es sich in dem vorliegenden Ausführungsbeispiel bei dem Stromnetz 2 um einen handelsüblichen Dreiphasen-Wechselstromkreis mit drei Außenleitern L₁ bis L₃, einem Neutralleiter N und einem zentralen Einspeisepunkt 8 handelt.

Ein erfindungsgemäßes System zur Bestimmung elektrischer Kenngrößen sieht vor, dass an das bestehende Stromnetz 2 eine zentrale Steuer- und Auswerteeinheit 3, eine zentrale Spannungsmesseinheit 4, sowie eine Mehrzahl Strommesseinheiten 5 angeschlossen werden.
Der Anschluss des erfindungsgemäßen Systems erfolgt dabei derart, dass die zentrale Spannungsmesseinheit 4 an einem einzigen definierten einspeisenahen Punkt innerhalb des Stromnetzes 2 angeschlossen wird und dass die Strommesseinheiten 5 dem jeweiligen Verbraucher 1 und jeweils einem der Außenleiter L₁ bis L₃ zugeordnet sind.

Die zentrale Spannungsmesseinheit 4 und die Strommesseinheiten 5 sind über Verbindungen 6 mit der zentralen Steuer- und Auswerteeinheit 3 verbunden, wobei sowohl der Spannungsmesseinheit 4 als auch den Strommesseinheiten 5 jeweils Speicherelemente 7 zugeordnet sind.
Die Verbindungen 6 zwischen zentraler Spannungsmesseinheit 4, Strommesseinheiten 5 und der zentralen Steuer- und Auswerteeinheit 3 werden erfindungsgemäß durch Modulation auf das Stromnetz 2 oder durch Drahtlos-Verbindungen realisiert.

In dem hier dargestellten Ausführungsbeispiel liegt die Spannungsmesseinheit 4 als baulich von der Steuer- und Auswerteeinheit 3 getrennt und somit als separates Bauteil vor.

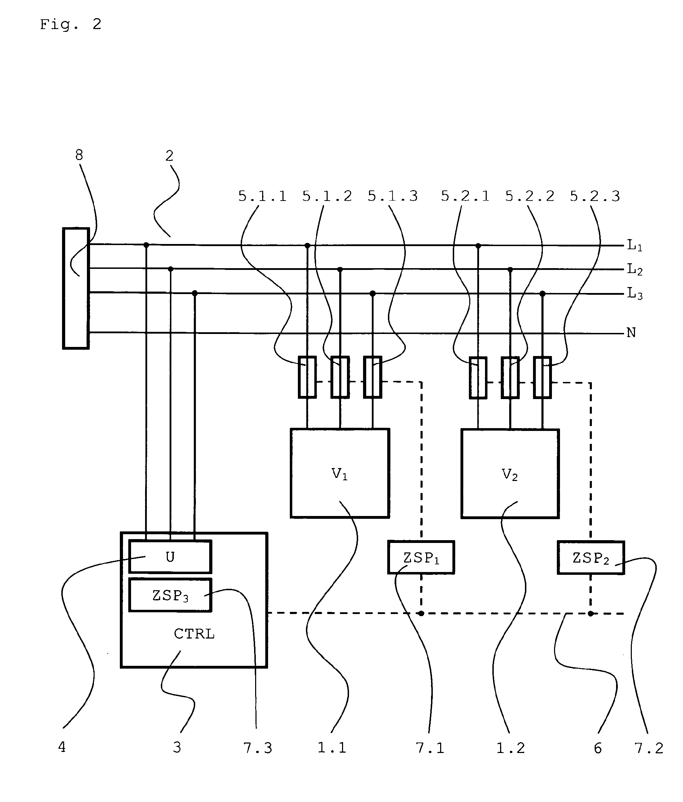

Fig. 2 zeigt ein identisches Stromnetz 2 mit Verbrauchern 1 und einem erfindungsgemäßen System zur Bestimmung elektrischer Kenngrößen.
Im Gegensatz zum Ausführungsbeispiel in Fig. 1 liegt die zentrale Spannungsmesseinheit 4 hier jedoch nicht als separates Bauteil vor, sondern ist zusammen mit dem ihr zugeordneten Speicherelement 7.3 in die zentrale Steuer- und Auswerteinheit 3 integriert.
Durch diese Integration lässt sich zum einen der Installationsaufwand für ein erfindungsgemäßes System reduzieren, zum anderen ist in diesem Fall die Verbindung zwischen zentraler Spannungsmesseinheit 4 und der zentralen Steuer- und Auswerteeinheit 3 über einen internen Prozessorbus (nicht dargestellt) der Steuer- und Auswerteeinheit 3 ausgebildet.

Bei beiden vorgestellten Ausführungsbeispielen wird ein erfindungsgemäßes Verfahren zur Bestimmung der elektrischen Kenngrößen, insbesondere der Wirkleistung und der Wirkenergie, in der nachfolgend beschriebenen Abfolge ausgeführt.

Zu Beginn wird in einem ersten Verfahrensschritt a) der Kenngrößenermittlungsvorgang durch die zentrale Steuer- und Auswerteeinheit 3 gestartet.

Nach dem Starten des Kenngrößenermittlungsvorgangs wird in einem zweiten Verfahrensschritt b) durch die Steuer- und Auswerteeinheit 3 über die Verbindungen 6, beziehungsweise in Ausführungsbeispiel 2 über den internen Prozessorbus der zentralen Steuer- und Auswerteeinheit 3, ein Signal zur zeitgleichen Messung einer Spannung und eines Stromes an die zentrale Spannungsmesseinheit 4 und an die Strommesseinheiten 5 ausgegeben.
Das ausgegebene Signal ist dabei erfindungsgemäß mit einem Zeitstempel versehen, welcher im späteren Verlauf des Verfahrens eine eindeutige zeitliche Zuordnung der gemessenen Spannungs- und Stromwerte ermöglicht.

In einem dritten Verfahrensschritt c) wird das, von der zentralen Steuer- und Auswerteeinheit 3 ausgegebene Signal mit Zeitstempel von der zentralen Spannungsmesseinheit 4 und den Strommesseinheiten 5 empfangen.
Der Empfang des Signals durch die zentrale Spannungsmesseinheit 4 und durch die Strommesseinheiten 5 startet die Messung der in dem Stromnetz 2 anliegenden Spannung und des, an dem jeweiligen Verbraucher 1 in den Leitern fließenden Stromes.

Nachdem das Signal von der zentralen Spannungsmesseinheit 4 und den Strommesseinheiten 5 empfangen wurde erfolgt in einem weiteren Verfahrensschritt d) die Durchführung der Messung der Augenblickswerte der, in dem Stromnetz 2 anliegenden Spannung und des, an dem jeweiligen Verbraucher 1 anliegenden Stromes, durch die zentrale Spannungsmesseinheit 4 und durch die Strommesseinheiten 5.
Die Messung von Spannung und Strom erfolgt erfindungsgemäß in einem definierten und von der Steuer- und Auswerteeinheit 3 vorgegebenen Erfassungszyklus.
Innerhalb dieses Erfassungszyklus wird zu einem ersten definierten Zeitpunkt t₀ jeweils ein erster Augenblickswert der Spannung und des, an dem jeweiligen Verbraucher 1 anliegenden Stromes gemessen.
Darauf aufbauend erfolgt innerhalb des Erfassungszyklus die Messung weiterer Augenblickswerte von Spannung und Strom durch die zentrale Spannungsmesseinheit 4 und die Strommesseinheiten 5 zu weiteren definierten Zeitpunkten tₙ.

Während des Ablaufens des Verfahrensschrittes d) erfolgt in der zentralen Spannungsmesseinheit 4 und in den Strommesseinheiten 5 erfindungsgemäß eine Zuordnung eines gemessenen Augenblickswertes der Spannung oder des Stromes zu dem jeweiligen Zeitpunkt t₀ bis tₙ des Erfassungszyklus als Wertepaar.
Die gebildeten Wertepaare werden darüber hinaus mit dem, von der zentralen Steuer- und Auswerteeinheit 3 ausgegebenen Zeitstempel versehen.

Die gebildeten und mit dem Zeitstempel versehenen Wertepaare werden anschließend in einem weiteren Verfahrensschritt e) über die Verbindungen 6 von der zentralen Spannungsmesseinheit 4 und den Strommesseinheiten 5 an die zentrale Steuer- und Auswerteeinheit 3 übertragen.
Im Falle des Ausführungsbeispiels nach Fig. 2 erfolgt die Übertragung der Wertepaare von der zentralen Spannungsmesseinheit 4 an die zentrale Steuer- und Auswerteeinheit 3 über den internen Prozessorbus der Steuer- und Auswerteeinheit 3.

Da in beiden der beschriebenen Ausführungsbeispiele je zwei Verbraucher 1 an das Stromnetz 2 angeschlossen sind, werden die Wertepaare der Strommesseinheiten 5 erfindungsgemäß zusätzlich mit einer Codierung versehen, welche eine Zuordnung der Wertepaare zu dem jeweiligen Verbraucher 1 ermöglicht.

Die übertragenen und mit den Zeitstempeln versehenen Wertepaare der Spannung und des Stromes zu den jeweiligen Zeitpunkten t₀ bis tₙ werden in einem weiteren Verfahrensschritt f) in der zentralen Steuer- und Auswerteeinheit 3 einander so zugeordnet, dass die Augenblickswerte der Spannung und des Stromes jeweils aus dem, mit dem gleichen Zeitstempel versehenen Wertepaar entnommen werden.

Aus den einander zugeordneten Augenblickswerten der Spannung und des Stromes werden in einem letzten Verfahrensschritt g) in der zentralen Steuer- und Auswerteeinheit 3 die gewünschten elektrischen Kenngrößen, insbesondere die Wirkleistung und die Wirkenergie, berechnet.

### Verwendete Bezugszeichen

- 1: Verbraucher
- 2: Stromnetz
- 3: zentrale Steuer- und Auswerteeinheit
- 4: zentrale Spannungsmesseinheit
- 5: Strommesseinheiten
- 6: Verbindungen
- 7: Speicherelemente
- 8: zentraler Einspeisepunkt

## Patentansprüche

1. System zur Bestimmung elektrischer Kenngrößen von Verbrauchern (1) in einem verzweigten Stromnetz (2), umfassend eine zentrale Steuer- und Auswerteeinheit (3), eine zentrale Spannungsmesseinheit (4), sowie eine Mehrzahl von Strommesseinheiten (5),
wobei die Strommesseinheiten (5) jeweils den Verbrauchern (1) zugeordnet sind,
wobei die zentrale Steuer- und Auswerteeinheit (3) über Verbindungen (6) mit der zentralen Spannungsmesseinheit (4) und mit den Strommesseinheiten (5) verbunden ist, wobei durch die zentrale Spannungsmesseinheit (4) Augenblickswerte einer Spannung und durch die Strommesseinheiten (5) Augenblickswerte eines Stroms messbar sind und übertragbar zur Verfügung gestellt werden und wobei durch die zentrale Steuer- und Auswerteeinheit (3) ein Kenngrößenermittlungsvorgang startbar und ein Signal zur zeitgleichen Messung der Augenblickswerte von Spannung und Strom an die zentrale Spannungsmesseinheit (4) und an die Strommesseinheiten (5) über die Verbindungen (6) ausgebbar ist, wobei diesem Signal ein, von der zentralen Steuer- und Auswerteeinheit (3) ausgegebener, Zeitstempel beigegeben ist,
und wobei die Übertragung der Augenblickswerte durch die Verbindungen (6) von der zentralen Spannungsmesseinheit (4) und den Strommesseinheiten (5) zu der zentralen Steuer- und Auswerteeinheit (3) erfolgt und
wobei die zentrale Steuer- und Auswerteeinheit (3) aus den Augenblickswerten von Spannung und Strom die elektrischen Kenngrößen berechnet.

2. System nach Anspruch 1,
wobei
der zentralen Spannungsmesseinheit (4) und/oder den Strommesseinheiten (5) Speicherelemente (7), durch welche gemessene Augenblickswerte für Spannung und Strom zwischenspeicherbar sind, zugeordnet sind.

3. System nach Anspruch 1 oder 2,
wobei
die Verbindung (6) der zentralen Steuer- und Auswerteeinheit (3) mit der zentralen Spannungsmesseinheit (4) und den Strommesseinheiten (5) durch Modulation auf das Stromnetz (2) erfolgt.

4. System nach Anspruch 1 oder 2,
wobei
die Verbindung (6) der zentralen Steuer- und Auswerteeinheit (3) mit der zentralen Spannungsmesseinheit (4) und den Strommesseinheiten (5) drahtlos ausgebildet ist.

5. System nach Anspruch 1 oder 2,
wobei
die zentrale Spannungsmesseinheit (4) in die zentrale Steuer- und Auswerteeinheit (3) integriert ist.

6. System nach Anspruch 5,
wobei
die Verbindung (6) der zentralen Steuer- und Auswerteeinheit (3) mit der zentralen Spannungsmesseinheit (4) über einen internen Prozessorbus erfolgt.

7. Verfahren zur Bestimmung elektrischer Kenngrößen von Verbrauchern (1) in einem Stromnetz (2), aufweisend folgende Verfahrensschritte:
a) Starten eines Kenngrößenermittlungsvorgangs durch die zentrale Steuer- und Auswerteeinheit (3),
b) Ausgeben eines Signals zur zeitgleichen Messung von Augenblickswerten einer Spannung und eines Stromes von der zentralen Steuerungs- und Auswerteeinheit (3) an die zentrale Spannungsmesseinheit (4) und an die Strommesseinheiten (5) über die Verbindungen (6), wobei diesem Signal ein, von der zentralen Steuer- und Auswerteeinheit (3) ausgegebener, Zeitstempel beigegeben ist,
c) Empfang des, von der zentralen Steuer- und Auswerteeinheit (3) ausgegebenen Signals mit Zeitstempel durch die zentrale Spannungsmesseinheit (4) und durch die Strommesseinheiten (5),
d) Durchführung der Messung der Augenblickswerte der Spannung und des Stromes durch die zentrale Spannungsmesseinheit (4) und die Strommesseinheiten (5), wobei innerhalb eines Erfassungszyklus mit vorgegebener Gesamtzeitdauer, jeweils beginnend mit einem ersten Augenblickswert zu einem definierten Zeitpunkt t₀ und darauf aufbauend, in einem festgelegten zeitlichen Intervall, weitere Augenblickswerte zu definierten Zeitpunkten tₙ gemessen werden, wobei eine Zuordnung eines Augenblickswertes und des jeweiligen Zeitpunktes als Wertepaar erfolgt und
wobei das jeweils eine Wertepaar mit dem, von der zentralen Steuerungs- und Auswerteeinheit (3), ausgegebenen Zeitstempel versehen wird,
e) Übertragung der Wertepaare mit Zeitstempel über die Verbindungen (6) von der zentralen Spannungsmesseinheit (4) und den Strommesseinheiten (5) an die zentrale Steuer- und Auswerteeinheit (3),
f) Zuordnen der gemessenen Werte der Spannung zu dem jeweiligen Zeitpunkt t₀ bis tₙ zu den jeweils gemessenen Werten des Stromes zu dem jeweiligen Zeitpunkt t₀ bis tₙ in der zentralen Steuer- und Auswerteeinheit (3), wobei die einander zugeordneten Werte der Spannung und des Stromes aus den jeweils mit dem gleichen Zeitstempel versehenen Wertepaar entnommen werden,
g) Berechnen der elektrischen Kenngrößen aus den, einander zugeordneten Augenblickswerten der Spannung und des Stromes in der zentralen Steuer- und Auswerteeinheit (3).

8. Verfahren nach Anspruch 7,
**dadurch gekennzeichnet,**
**dass** die, innerhalb eines Erfassungszyklus in Verfahrensschritt d), zugeordneten Wertepaare in jeweils einem Wertepaarblock zusammengefasst werden.

9. Verfahren nach Anspruch 7 oder 8,
**dadurch gekennzeichnet,**
**dass** innerhalb der zentralen Steuer- und Auswerteeinheit (3) eine Ordnung der übertragenen Wertepaare oder Wertepaarblöcke bezüglich deren jeweils zugeordneten Zeitstempeln erfolgt.

10. Verfahren nach einem der Ansprüche 7 bis 9,
**dadurch gekennzeichnet,**
**dass** nach Verfahrensschritt d) mindestens ein Wertepaar oder Wertepaarblock mit Zeitstempel temporär in dem Speicherelement (7) der zentralen Spannungsmesseinheit (4) und/oder den Strommesseinheiten (5) gespeichert wird.
